# EUROPEAN PATENT SPECIFICATION

(11) **EP 1 307 387 B1**
(45) Date of publication and mention of the grant of the patent: **14.04.2010**
(21) Application number: 01906946.7
(22) Date of filing: 02.02.2001
(51) Int. Cl.: B05C 5/02

(54) **DISPOSABLE SYRINGE DISPENSER SYSTEM**
EINWEGSPRITZEN SPENDERSYSTEM
SYSTEME DE DISTRIBUTION DE SERINGUES JETABLES

(30) Priority: 30.06.2000 US 607310
(43) Date of publication of application: 07.05.2003
(73) Proprietor: Brewer Science, Inc., Rolla, MO 65401-9926 (US)
(72) Inventor: PAGEL, Russell, T., Rolla, MO 65401 (US); MCCUTCHEON, Jeremy, W., Rolla, MO 65401 (US); KOHNE, Jeffrey, L., Rolla, MO 65401 (US)
(74) Representative: UEXKÜLL & STOLBERG
(86) International application number: PCT/US2001/003544
(87) International publication number: WO 2002/002424

(56) References cited:
- US-A- 3 982 724
- US-A- 4 030 640
- US-A- 4 403 764
- US-A- 4 715 517
- US-A- 4 921 133

## Description

### BACKGROUND OF THE INVENTION

### Field of the Invention

The present invention is broadly concerned with dispenser devices and methods for precisely dispensing viscous, flowable materials. More particularly, the invention pertains to embodiments of such inventions and methods wherein accurate quantities of material can be repeatedly dispensed while minimizing the possibility of air drying of the material adjacent the dispenser outlet. In preferred practice the dispensers of the invention include a deformable outlet tube with a flow controlling assembly comprising a tube-engaging element (e.g., a roller) supported by an actuator linkage so as to selectively move the element to deform the outlet tube with continued movement of the element serving to generate a suction force adjacent the tube outlet end so that the flowable material at the end is drawn into the confines of the tube.

### Description of the Prior Art

In the manufacture of integrated circuits, materials such as photo sensitive resins (photoresists) are applied to wafers, and the wafers are spun to evenly distribute the materials. Most photoresists and related materials are extremely expensive, and therefore care must be taken to use only the minimum amount of the composition necessary to accomplish the desired end. In practice, computer controlled syringe-type dispensers have been used to dispense materials of this character. These dispensers include a replaceable syringe supported on an actuator housing, with the syringe including a material reservoir and an elongated deformable outlet tube. Various types of controllers are used to selectively pinch off the outlet tube to terminate material flow from the syringe.

For example, U.S. Patent Nos. 4,030,640, 3,982,724 and 5,033,656 describe various dispensers which include pinch-type flow controllers. The '724 patent makes use of a micrometer stop which is used to pinch off a deformable outlet tube. Similarly, the '640 patent employs a conical pinch element for this purpose. The '656 patent makes use of a pair of pinch elements.

However, the viscous nature of many materials, and particularly those used in the electronics industry, often cause a terminal droplet to form at the outlet end of material dispensing tubes. As a consequence, the material may dry at the end of the tube, requiring cleaning which can waste the materials, thus making simple pinch-type dispensers unsuitable.

In addition, commercial systems are available which use a mechanical apparatus to control the plunger of delivery syringes. However, these devices are large and somewhat expensive, and generally require the use of additional fluid tubing to connect the dispenser apparatus to the point where fluid is to be dispensed. This can be a problem if dispensing operations are interrupted or terminated for significant periods of time, in that the material may tend to dry within the tubing. In addition, this causes extra waste of materials in that the additional fluid tubing and associated fittings must be filled with fluid before use.

Pneumatic point-of-use syringe systems also exist that employ various methods of control of the pressure or vacuum in the syringe barrel to control the dispensing cycle. When used with materials that flow (as opposed to pastes) the materials are prevented from dripping by the application of a vacuum to the upper part of the syringe barreL The level of vacuum must be high enough to prevent dripping yet not high enough to pull air through the dispenser tip and into the syringe barrel. Unfortunately, the level of vacuum required varies with the characteristics of the fluid and dispenser tip, as well as the amount of fluid remaining in the syringe barrel.

US-A-4,403,764 discloses a method according to the preamble of claim 12 and a dispenser according to the preamble of claim 1, for controlling flow of work materials using a pinch valve to pinch off the flow within a deformable tube. The pinch valve comprises a spring-loaded car means for rolling reciprocating movement.

### SUMMARY OF THE INVENTION

This invention relates to a dispenser as claimed in Claim 1 and to a method as claimed in Claim 12.

The present invention provides an improved dispenser for viscous flowable materials of compact, simplified design which overcomes many of the problems with prior art dispensers. To this end, the dispensers of the invention include a reservoir for holding materials to be dispensed, with a deformable outlet tube coupled with the reservoir and presenting an outlet end. A flow controlling assembly including a tube-engaging pinch element and an actuator are used to selectively move the element between a flow-permitting position adjacent the tube and a flow-blocking, tube-deforming engagement with the tube. To this end, the pinch element operates against an opposed backing surface, i.e., the outlet tube is disposed between the pinch element and backing surface. Furthermore, and very importantly, the element is moved by the actuator along the tube in a direction away from the outlet end in order to create a suction which draws material at the outlet end into the tube. This effectively eliminates problems associated with dripping and/or drying of material at the outlet end of the tube.

In preferred forms, the dispenser of the invention includes a small, upright housing adapted to receive a standard, removable dispenser syringe. The housing is configured to accept the syringe body with the filtered depending syringe outlet tube extending below the housing. A flow controlling assembly is located within the housing and includes a roller or similar tube-engaging element together with an actuary linkage assembly which may be pneumatically or mechanically operated. Advantageously, the roller is moved through an arcuate path to first engage the outlet tube and then moved upwardly along the length thereof to create the desirable suction at the end of the outlet tube. In order to achieve the best and most accurate flow control, the pinch closure effected between the pinch element and backing surface is resilient and biased. Such may be obtained by a resilient bias associated with either the pinch element or the backing surface.

### BRIEF DESCRIPTION OF THE DRAWINGS

Figure 1 is a perspective, exploded view of the preferred dispenser housing, with a replaceable syringe assembly normally fitted within and supported by the housing;
Fig. 2 is a front view of the preferred dispenser of the invention, with a syringe mounted therein;
Fig. 3 is a vertical sectional view taken along the line 3-3 of Fig. 2 and depicting the dispenser in its open, flow-permitting position;
Fig. 4 is an enlarged, fragmentary vertical sectional view illustrating the dispenser of Fig. 2 during the initial stages of operation thereof to stop flow of material from the dispenser;
Fig. 5 is a fragmentary vertical sectional view illustrating the dispenser in its flow-preventing position and with a negative pressure created at the syringe outlet;
Fig. 6 is an enlarged, fragmentary, exploded perspective view of the components of the preferred flow-controlling assembly of the dispenser;
Fig. 7a is an essentially schematic side view of an alternate flow-controlling assembly making use of a mechanical linkage and an associated resilient bearing block, and shown with the assembly in its open, flow-permitting position;
Fig. 7b is a view similar to that of Fig. 7a, but illustrating the flow-controlling assembly in its alternate flow-blocking position;
Fig. 8a is an essentially schematic side view of another type of flow-controlling assembly, making use of a spring loaded mechanical linkage, and depicting the flow-controlling assembly in its open, flow-permitting position;
Fig. 8b is a view similar to that of Fig. 8a, but illustrating the flow-controlling assembly in its flow-blocking position;
Fig. 9a is an essentially schematic side view of a still further type of flow-controlling assembly, making use of a spring-biased dogleg linkage, and showing the assembly in its open position; and
Fig. 9b is a view similar to that of Fig. 9a, but depicting the flow-controlling assembly in its closed flow-blocking position.

### DETAILED DESCRIPTION OF THE PREFERRED EMBODIMENTS

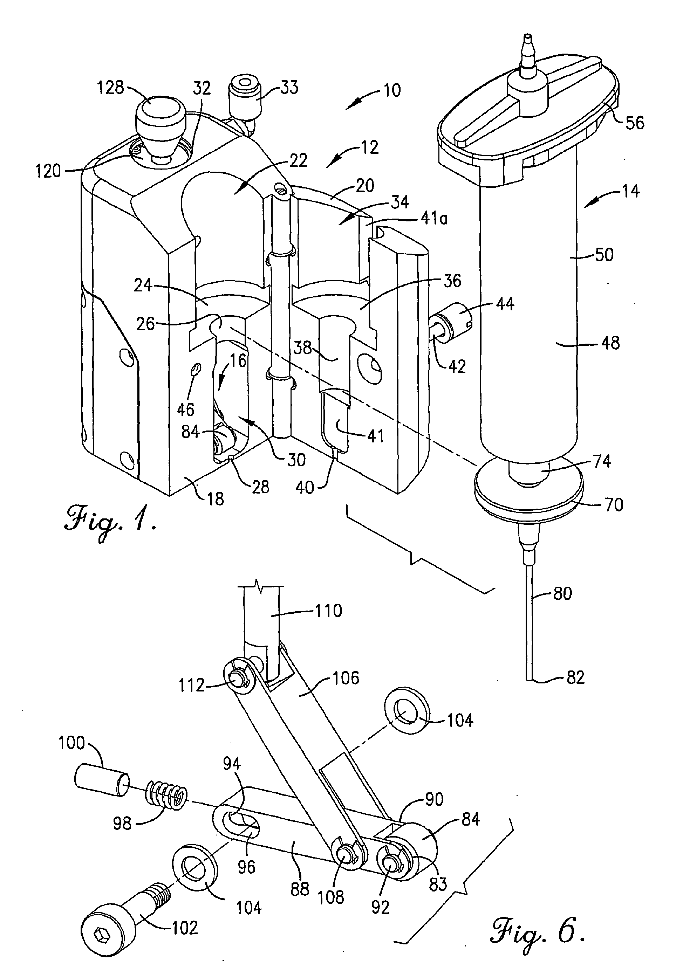

Turning now to the drawings, Figs. 1-3 depict a preferred dispenser 10 in accordance with the invention. Broadly spearing, the dispenser 10 includes a housing 12, a replaceable reservoir 14, and a flow controlling assembly 16 supported within the housing 12 and operable to precisely control the flow of material from the reservoir 14.

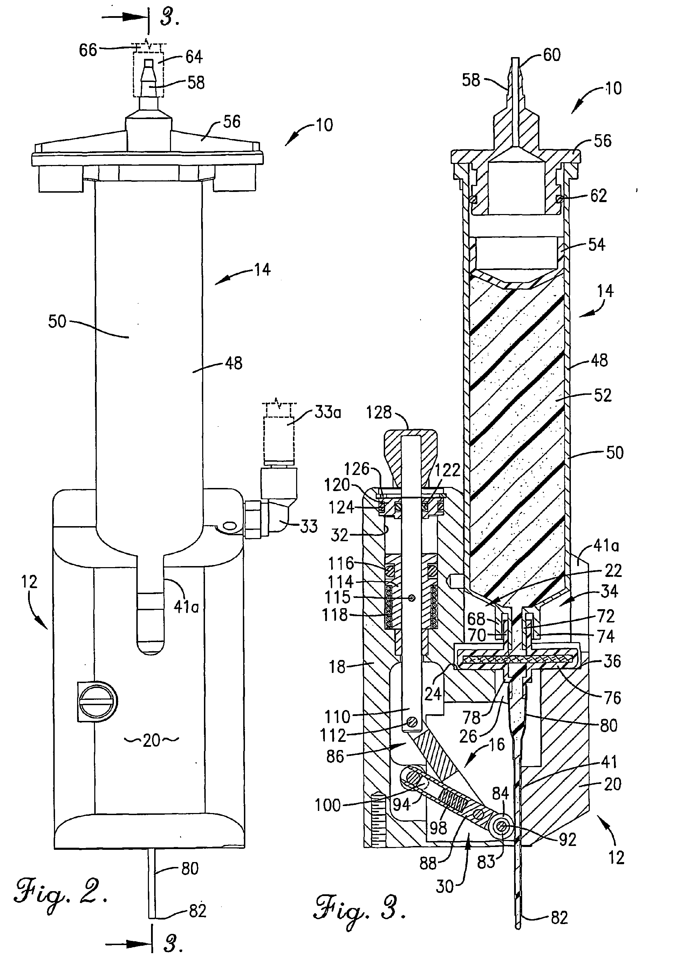

In more detail, the housing 12 includes a main body 18 having a hingedly mounted door 20. The body 18 presents an upper, syringe-supporting recess 22 with a bottom shelf 24. In addition, the body has a semi-cylindrical opening 26 extending downwardly from shelf 24 and a lowermost, semi-cylindrical opening 28 at the base of the body. A chamber 30 having an opened vertical end is formed in the body 18 below the shelf 24 as best seen in Fig. 3. The body 18 also has a stepped vertical bore 32 formed therein astride recess 22 which communicates with chamber 30. Additionally, the body has a pneumatic elbow fitting 33 secured thereto and communicating with bore 32; a pneumatic line 33a is coupled to the fitting 33.

The door 20 also has an upper recess 34 with a lower shelf 36, together with a downwardly extending semi-cylindrical opening 38 and a smaller semi-cylindrical opening 40 at the base of the door. A backing surface 41 is also a part of door 20 (Fig. 1) and is important for purposes to be described. As illustrated in Fig. 3, when the door 20 is closed against body 18, the recesses 22, 34 shelves 24, 36, and openings 26, 38 and 28, 40 come in to adjacency. A vertical observation slot 41a is formed in door 20 and extends from the upper margin of the door downwardly to about the level of shelf 36. A latch screw 42 with a head 44 is shiftably mounted in door 20 and is receivable within a corresponding latch opening 46 formed in body 18. This way, the door 20, when closed, may be locked in position relative to main body 18.

The reservoir 14 is in the form of an elongated, normally upright syringe 48 having a tubular reservoir body 50 adapted to hold a viscous, flowable material 52. The body 50 is equipped with a cup-shaped pneumatic piston 54 which sits atop material 52 and is slidable within the reservoir body. The piston 54 is moveable under the influence of positive pneumatic pressure. To this end, the reservoir body 50 has an upper cap 56 presenting an upwardly projecting tubular nipple 58 which presents an internal passageway 60 communicating with the upper surface of piston 54 remote from material 52. The cap 56 is sealed to the upper end of body 50 by an O-ring 62. As depicted in Fig. 2, the nipple 58 is adapted to receive a pneumatic fitting 64 coupled to a pneumatic hose 66. The lower end of syringe 48 includes a tubular connection fitting 68 which receives the upper end of an annular filter 70. As best seen in Fig. 3, the fitting 68 includes an inner tubular segment 72 adapted to receive the upper end of filter 70 and communicating with the interior of body 50, with a surrounding, coaxial outer tubular segment 74. The filter 70 has a radially enlarged section 76 which rests atop the adjacent shelves 24, 36 and presents a stepped, tubular lower section 78.

An elongated, synthetic resin, deformable outlet tube 80 is secured to the lower section 78 of filter 70. As illustrated in Fig. 3, the tube 80 extends downwardly, passing through the cylindrical opening defined by the mated openings 28, 40, and terminates with an outlet end 82 below body 18 and/or 20.

The flow-controlling assembly 16 includes a pinch element, here in the form of a roller 84, which is adapted to engage the deformable outlet tube 80 for controlling flow of material 52 from the syringe 48. The roller 84 is in turn supported by two bearings 83 on a pneumatically operated linkage assembly 86. In detail, the assembly 86 includes a lower pivot arm 88 (see Fig. 6) having a bifurcated outer end 90 with a roller pin 92 supporting the roller 84. The arm 88 has a bore 94 in the end thereof remote from roller 84, as well as an elongated cross bore 96. A coil spring 98 is located within bore 94, and is held therein by means of a plunger 100 and shoulder screw 102 passing through bore 96 and having washers 104 mounted thereon.

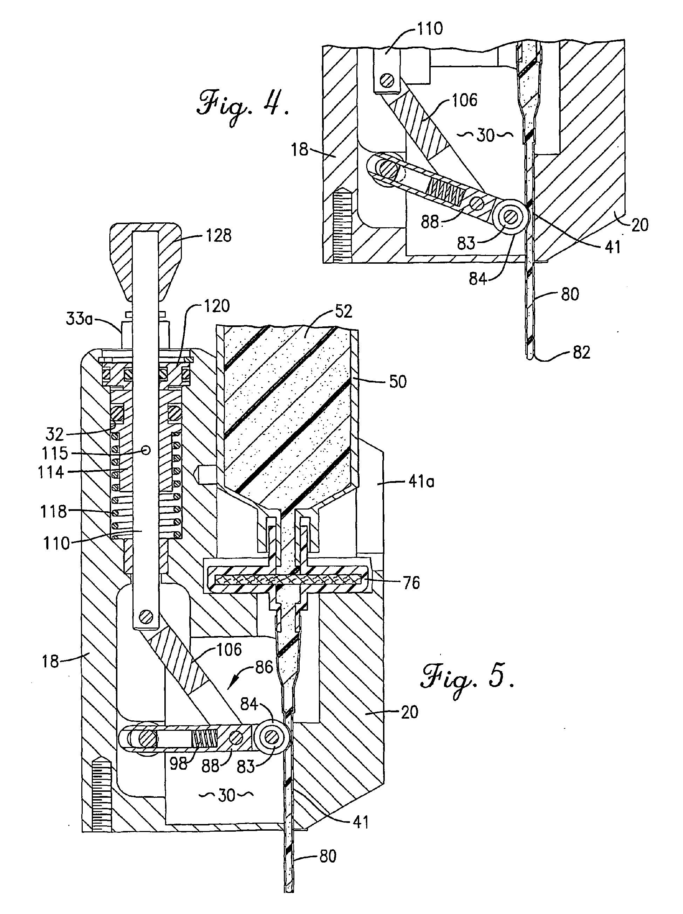

The linkage assembly 86 also has a cylinder link 106 which is pivotally secured to arm 88 adjacent the outer end thereof, by means of pin 108. The upper end of link 106 is pivotally secured to the lower end of piston rod 110 via pin 112. As seen in Fig. 5, the piston rod 110 is secured to pneumatic piston 114 by roll pin 115 and is vertically moveable within stepped bore 32 of housing body 18. As best seen in Fig. 3, the piston 114 is equipped with an O-ring seal 116, and return spring 118. The rod 110 extends upwardly from piston 114 through a pneumatic seal cap 120. The seal cap 120 has inner and outer O-ring seals 122, 124 as well as retaining ring 126. The rod 110 has an uppermost knob 128 secured thereto above seal cap 120. The pneumatic fitting 33 of housing body 18 communicates with bore 32 above piston 114.

In the use of dispenser 10 with the lines 33a and 66 in place, door 20 is first opened as illustrated in Fig. 1, by unfastening screw 42, and an assembled syringe 48 is positioned within housing door 20 with the lower surface of filter 70 resting on shelf 36. The knob 128 is then depressed fully to place the flow controlling assembly 16 in its open position. Door 20 (with the syringe 48 installed) is then closed against body 18 and fastened with screw 42. Upon fastening door 20 to body 18, knob 128 is released, thus closing the assembly 16 and pinching tube 80 between roller 84 and door surface 41. The initial step of depressing and then releasing knob 128 effectively seats the tube 80 and insures a positive pinch closure when the assembly 16 is in its flow-blocking position.

In the rest position or off state of dispenser 10 as depicted in Fig. 5, positive pressure is continually delivered via hose 66 to syringe body 50 and particularly against the upper face of syringe piston 54. When it is desired to dispense a selected quantity of material 52 from the dispenser 10, positive pressure air from line 33a is delivered into stepped bore 32 above piston 114. This causes downward movement of the piston 114 and piston rod 110 which in turn causes pivot arm 88 and roller 84 to pivot downwardly so that the roller 84 disengages with the adjacent outlet tube 80. It will be appreciated that such downward movement is against the bias piston spring 118. At this time the pressurized air delivered via hose 66 to syringe body 50, and particularly against the upper face of syringe piston 54 causes an even flow of the material 52 from outlet end 82 of tube 80 as depicted in Fig. 3. When the desired quantity of material has been dispensed, the positive pressure delivered through line 33a is relieved, and the bias piston spring 118 causes upward movement of piston 114 and piston rod 110 which in turn causes pivot arm 88 and roller 84 to pivot upwardly so that the roller 84 comes into engagement with the adjacent outlet tube 80, as illustrated in Fig. 4. As the upward pivoting movement of the arm 88 and roller 84 continues, the roller first engages and deforms the tube 80 (with the opposing surface 41 of the door 20 serving as a backing for the tube) to first restrict and then completely shut off flow of material 52. However, still further movement of the roller 84 upwardly along the length of the tube 80 to the fully closed position depicted in Fig. 5 generates a small suction force within the tube 80 below the roller 84, and particularly at outlet end 82. This suction force draws the material 52 within the lower end of the tube 80 upwardly from the end 82 so that such material is fully within the confines of the tube 80. This eliminates any droplet of material depending from the outlet end 82, which would be subject to air drying. It will also be seen that the spring 98 assumes a resilient closure of the tube 80.

Of course, when it is desired to again dispense material, positive pressure air from line 33a is delivered into stepped bore 32 above piston 114 causing piston 114 and rod 110 to move downwardly, thereby pivoting the arm 88 and roller 84 away from tube 80. The positive pressure that is constantly applied via line 66 against upper face of syringe piston 54 forces material 52 from the outlet end 82. It will be appreciated that the link 88, plunger 100, spring 98 and pivotal screw 102 create a self-adjusting resilient, spring-biased pinch mechanism. As motive force from 110 acts on flow controlling assembly 16, links 106 and 88 continually adjust radially about pivotal screw 102 by compression of spring 98. This radial motion serves as a "no-wedge" system and eliminates binding. This "no-wedge" system also automatically adjusts to varying tubing sizes and thicknesses. Resilient compressive forces applied by roller 84 can also be adjusted by changing spring 98 to lesser or greater values to accommodate an even wider range of tubing geometries. This "no-wedge" system also reduces wear and undue stress on tube 80, which increases tube life. A further advantage of the hinged door design of dispenser 10 is the method of front/side loading of reservoir 14. This method of loading and unloading (as opposed to straight through or top loading of the reservoir 14) is the elimination of contamination of the internal mechanism by tube 80 during loading and unloading. This contamination is primarily due to material present in tube 80 which is not contained therein by flow controlling assembly 16. This increases the reliability and uptime of the dispenser 10. Also, the manually operated knob 128 serves as a purging mechanism for removing air from the syringe and as a means of manually overriding the dispenser controller.

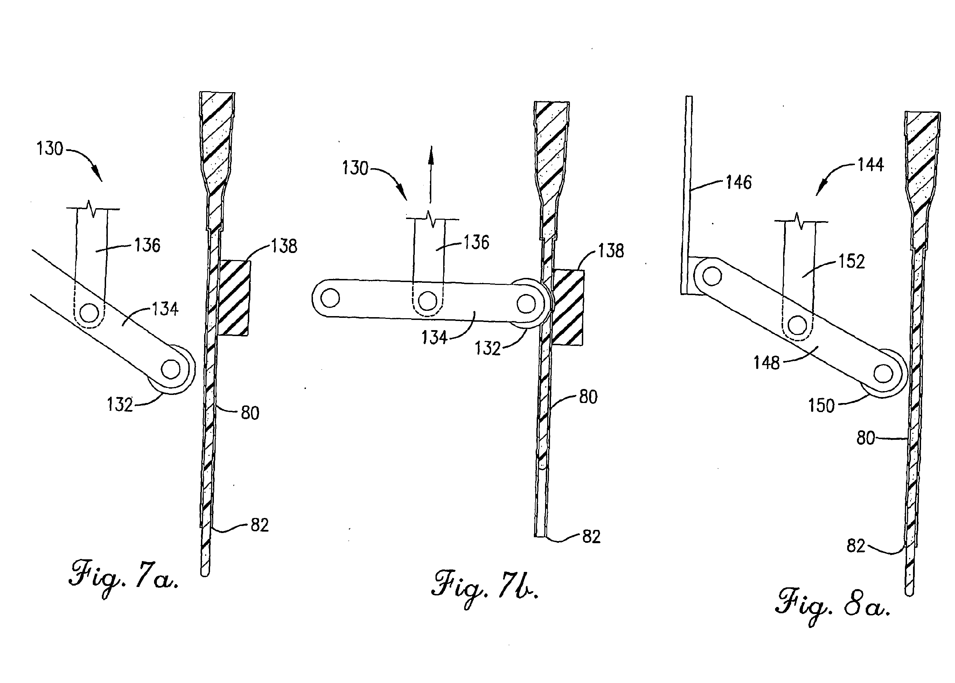

While a pneumatically operated linkage assembly 86 is presently preferred, the invention is not so limited. For example, and referring to Figs. 7a and 7b, a mechanical linkage assembly 130 may be provided for supporting a tube-deforming roller 132. In this instance, the assembly 130 is made up of two linkage bars 134 and 136. In Fig. 7a, the roller 132 is in its retracted, flow-permitting position. When it is desired to stop fluid flow in accordance with the invention, an upwardly directed force is imparted to linkage bar 134, resulting in pivotal movement of the roller 132 so that the roller first engages and deforms the tube 80 and then, through continued upward movement, generates the desirable suction force within the tube 80 below the roller. In this embodiment, a resilient backing block 138 is positioned within door 20 behind the tube 80 so that the pinch closure effected by the assembly 130 is resiliently maintained.

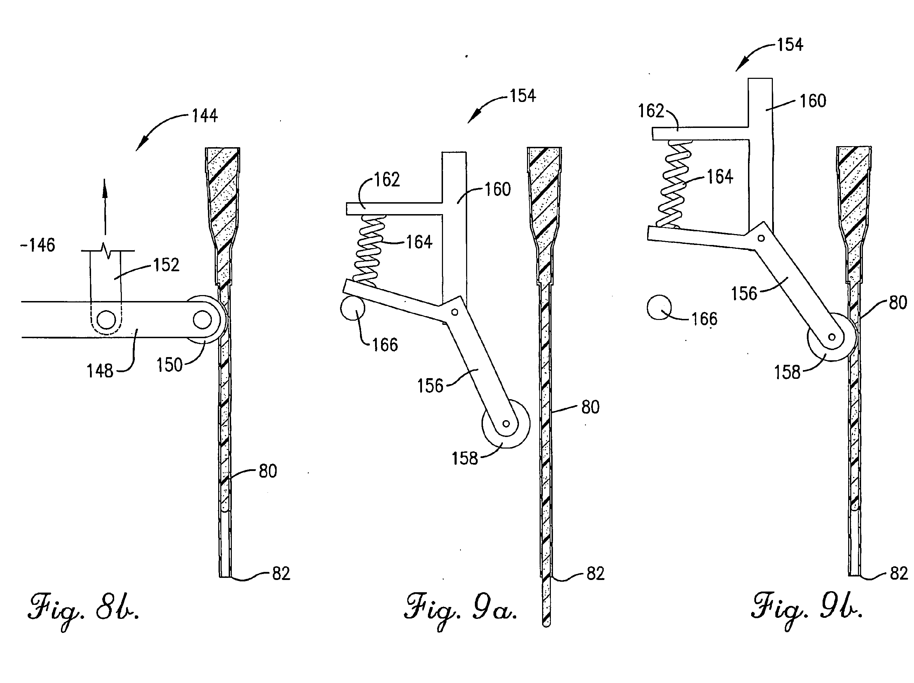

Figs. 8a and 8b illustrates another type of mechanical linkage 144. In this case, the assembly includes a leaf spring 146 pivotally supporting a pivot arm 148, the latter having a roller 150 at its outboard end. An intermediate linkage bar 152 is pivotally coupled to the arm 148 intermediate its ends. In Fig. 8a, the roller 150 is in the flow-permitted position; when an upwardly directed force is imparted to bar 152 (Fig. 8b) the arm 148 is pivoted upwardly against the bias of the leaf spring 146 until the roller 150 stops flow of material through the tube 80 and creates the suction force at outlet end 82. Again, provision of the leaf spring 146 yields a resilient closure of the tube 80.

A final illustrative embodiment is shown in Figs. 9a and 9b. Here, the linkage assembly 154 includes a dogleg link 156 supporting a roller 158. The link 156 has a spring link 160 of inverted L-shaped configuration pivotally secured thereto. The link 160 has a rearwardly extending arm 162, with a coil spring 164 located between the arm 162 and the end of dogleg link 156 remote from roller 158. In the flow-permitting position of Fig. 9a, the remote end of dogleg link 156 abuts a stationary cross pin 166. However, when it is desired to terminate flow through the tube 80, an upwardly directed force is imparted to link 160 (Fig. 9b) thereby moving the entire assembly 154 away from cross pin 166. Accordingly, spring 164 acts to pivot dogleg link 156 and roller 158 toward and into engagement with outlet tube 80. Again, this causes termination of flow through the tube 80 and also, by virtue of continued upward movement of roller 158 along the length of tube 80, generation of the desired suction force below the roller, with a resilient closure afforded by the spring 164.

## Claims

1. A dispenser (10) comprising:
a reservoir (50) for holding a viscous material (52) to be dispensed;
a deformable outlet tube (80) operatively coupled with said reservoir (50) and presenting an outlet end (82);
a flow controlling assembly (16) including a tube-engaging element (84, 132, 150, 158) and an actuator coupled with said element (84) in order to selectively move the element from a flow-permitting position spaced from said tube into material flow-blocking, tube-deforming engagement with said tube (80), and to move the element along the tube in a direction away from said outlet end to create a suction drawing material at said outlet end into the tube,
said assembly operable to resiliently engage said tube (80) when said element (84) is in the material flow-blocking position thereof;
**characterized in that**
said actuator comprises a linkage (86) operatively supporting said element (84), said linkage being selectively shiftable for moving said element into said engagement with said tube (80), and to move the element along the tube for creating said suction.

2. The dispenser of claim 1, said actuator operative to repeatedly move said element (84) between said flow-permitting position and said engagement with said tube.

3. The dispenser of claim 1, said element comprising a tube-engaging roller (84).

4. The dispenser of claim 1, said linkage (86) being pneumatically actuatable.

5. The dispenser of claim 1, said actuator operable to move said element (84) along an arcuate path.

6. The dispenser of claim 1, said element (84) being spring biased toward said tube (80).

7. The dispenser of claim 1, said reservoir (50) comprising a syringe body (50) including a shiftable piston (54) disposed above the level of material within the body, said piston (54) being moveable under the influence of pneumatic pressure applied against the face of the piston remote from said material.

8. The dispenser of claim 1, said actuator comprising a mechanical linkage.

9. The dispenser of claim 1, said dispenser including a housing (12) supporting said flow controlling assembly, said reservoir (14) and tube (80) being received within said housing.

10. The dispenser of claim 1, including a spring (98) biasing said element (84) against said tube (80) when the element is in said flow-blocking position thereof.

11. The dispenser of claim 1, including a backing member (41) in opposed relationship to said element (84) with said tube (80) disposed between the element and backing member, said backing member being resilient and deformable when said element is moved to said flow-blocking position thereof.

12. A method of dispensing a flowable material (52) from a reservoir (14) holding the material, there being a deformable outlet tube (80) operatively coupled with said reservoir (14) and presenting an outlet end (82), said method comprising the steps of:
allowing a selected quantity of said material to flow from the reservoir, through said tube (80) and out said outlet end (82);
thereafter stopping the flow of material by deforming said outlet tube (80);
creating a suction force adjacent said outlet end (82) in order to draw material proximal to the outlet end into the tube (80),
said deforming step comprising the step of creating a resiliently applied force against said tube (80),
said flow-stopping and suction-creating steps comprising the step of causing a tube-deforming element to come into engagement with said tube (80) between said reservoir (50) and said outlet end (82), and moving the element along the tube (80) in a direction away from said outlet end (82),
**characterized in that** there is a mechanical linkage assembly (86, 130, 144, 154) supporting said element (84, 132, 150, 158), and
including the step of causing movement of the linkage assembly (86, 130, 144, 154) to thereby cause said element (84, 132, 150, 158) to come into engagement with said tube (80) and to move the element along the tube.

13. A method of claim 12, there being a linkage assembly supporting said element, and including the step of moving said element by subjecting the linkage assembly to a positive pressure.

14. A method of claim 12, including the step of creating a positive pressure within said reservoir to cause said material to flow from the reservoir.

15. The method of claim 12, including the step of causing a spring-biased tube-deforming element to come into engagement with said tube in order to create said resiliently applied force.

16. The method of claim 12, including the step of providing a tube-deforming element and an opposed backing member with said tube disposed between said element and said member, said memberbeing resilient and deformable, said tube-deforming step comprising moving said element into flow-blocking relationship with said tube and deforming said member, thereby creating said resiliently applied force.

## Patentansprüche

1. Spender (10), aufweisend:
einen Behälter (50) zum Aufnehmen eines viskösen Materials (52), das abgegeben werden soll;
ein deformierbares Abgaberöhrchen (80), das operativ mit dem Behälter (50) gekoppelt ist und das ein Abgabeende (82) darstellt;
eine Durchsatzsteuerungsanordnung (16) einschließlich eines Rohreingriffselements (84, 132, 150, 158) und eines Betätigers, der mit dem Element (84) gekoppelt ist, um das Element selektiv von einer strömungszulassenden Position, die von dem Rohr entfernt ist, in eine Materialabsperrposition zu bewegen, bei der Verformungseingriff mit dem Röhrchen (80) besteht, und um das Element entlang des Röhrchens in Richtung weg von dem Auslaßende zu bewegen und einen Sog zu erzeugen, der Material vom Auslaßende in das Röhrchen zieht,
wobei die Anordnung nachgiebig gegen das Röhrchen (80) drückt, wenn sich das Element (84) in der Materialflußabsperrposition befindet;
**dadurch gekennzeichnet, daß**
der Betätiger ein Gestänge (86) aufweist, welches das Element (84) funktionsmäßig trägt, wobei das Gestänge selektiv verlagerbar ist, um das Element in Eingriff mit dem Röhrchen (80) und entlang des Röhrchens zu bewegen, um den Sog zu erzeugen.

2. Spender nach Anspruch 1, wobei der Betätiger das Element (84) wiederholt zwischen der Strömungsfreigabeposition und dem Eingriff mit dem Röhrchen bewegen kann.

3. Spender nach Anspruch 1, wobei das Element eine Röhrcheneingriffsrolle (84) aufweist.

4. Spender nach Anspruch 1, wobei das Gestänge (86) pneumatisch betätigbar ist.

5. Spender nach Anspruch 1, wobei der Betätiger das Element (84) entlang eines bogenförmigen Weges bewegen kann.

6. Spender nach Anspruch 1, wobei das Element (84) von einer Feder gegen das Röhrchen (80) gedrückt wird.

7. Spender nach Anspruch 1, wobei der Behälter (50) einen Spritzenkörper (50) mit einem verschiebbaren Kolben (54) aufweist, der über dem Materialspiegel innerhalb des Körpers angeordnet ist, wobei der Kolben (54) unter dem Einfluß von pneumatischen Druck bewegbar ist, der gegen die dem Material abgewandte Kolbenseite wirkt.

8. Spender nach Anspruch 1, wobei der Betätiger ein mechanisches Gestänge aufweist.

9. Spender nach Anspruch 1, wobei der Spender ein Gehäuse (12) aufweist, das die Durchsatzsteuerungsanordnung trägt, wobei der Behälter (14) und das Röhrchen (80) in dem Gehäuse aufgenommen sind.

10. Spender nach Anspruch 1, mit einer Feder (98), die das Element (84) gegen das Röhrchen (80) drückt, wenn sich das Element in der Strömungsabsperrposition befindet.

11. Spender nach Anspruch 1, mit einem dem Element (84) gegenüberliegenden Stützteil (41), wobei das Röhrchen (80) zwischen dem Element und dem Stützteil angeordnet und das Stützteil nachgiebig und verformbar ist, wenn das Element in die Strömungsabsperrposition bewegt wird.

12. Verfahren zum Abgeben eines fließfähigen Materials (52) aus einem das Material enthaltenden Behälter (14), wobei ein verformbares Auslaßröhrchen (80) operativ mit dem Behälter (54) gekoppelt ist und ein Auslaßende (82) darstellt, wobei das Verfahren die Schritte aufweist:
Zulassen, daß eine ausgewählte Menge des Materials aus dem Behälter durch das Röhrchen (80) und das Auslaßende (82) ausströmen kann;
anschließend Unterbrechen der Materialströmung durch Verformen des Auslassröhrchens (80);
Erzeugen einer Saugkraft nahe dem Auslaßende (82), um Material nahe dem Auslaßende in das Röhrchen (80) zu ziehen,
wobei der Verformungsschritt den Schritt des Erzeugens einer nachgiebig angelegten Kraft gegen das Röhrchen (80) umfaßt,
wobei die Strömungsunterbrechungs- und Sogerzeugungsschritte den Schritt umfassen, ein röhrchenverformendes Element in Eingriff mit dem Röhrchen (80) zwischen dem Behälter (50) und dem Auslaßende (82) zu bringen und das Element entlang des Röhrchens (80) in Richtung weg von dem Auslaßende (82) zu bewegen,
**dadurch gekennzeichnet, daß** eine mechanisches Gestänge (86, 130, 144, 154) das Element (84, 132, 150, 158) trägt, und mit dem Schritt,
eine Bewegung des Gestänges (86, 130, 144, 154) zu bewirken, um **dadurch** das Element (84, 132, 150, 158) in Eingriff mit dem Röhrchen (80) zu bringen und das Element entlang des Röhrchens zu bewegen.

13. Verfahren nach Anspruch 12, wobei ein das Element tragendes Gestänge vorgesehen ist, und mit dem Schritt, das Element zu bewegen, indem das Gestänge einem Überdruck ausgesetzt wird.

14. Verfahren nach Anspruch 12, mit dem Schritt des Erzeugens eines Überdrucks innerhalb des Behälters, um zu bewirken, daß Material aus dem Behälter strömt.

15. Verfahren nach Anspruch 12, mit dem Schritt, zu bewirken, daß ein federbelastetes, röhrchenverformendes Element in Eingriff mit dem Röhrchen gelangt, um die nachgiebig angelegte Kraft zu erzeugen.

16. Verfahren nach Anspruch 12, mit dem Schritt des Vorsehens eines röhrchenverformenden Elements und eines gegenüberliegenden Stützteils, wobei das Röhrchen zwischen dem Element und dem Teil liegt und das Teil nachgiebig und verformbar ist, wobei der Röhrchenverformungsschritt das Bewegen des Elements in eine Strömungsabsperrbeziehung mit dem Röhrchen und Verformen des Elements umfaßt, wodurch die nachgiebig angelegte Kraft erzeugt wird.

## Revendications

1. Distributeur (10) comprenant :
un réservoir (50) permettant de contenir une matière visqueuse (52) à distribuer ;
un tube déformable (80) de sortie, couplé en cours de fonctionnement avec ledit réservoir (50) et présentant une extrémité (82) de sortie ;
un ensemble (16) de régulation d'écoulement comprenant un élément (84) d'engagement de tube (84, 132, 150, 158) et un actionneur couplés audit élément (84), afin de déplacer de manière choisie l'élément à partir d'une position permettant l'écoulement, espacée dudit tube en engagement de blocage d'écoulement, de déformation de tube avec ledit tube (80), et de déplacer l'élément le long du tube dans un sens d'éloignement de ladite extrémité de sortie, afin de créer une succion aspirant de la matière au niveau de ladite extrémité de sortie dans le tube,
ledit ensemble pouvant fonctionner pour s'engager de manière résiliente dans ledit tube (80) quand ledit élément (84) se trouve dans sa position de blocage d'écoulement de matière
**caractérisé en ce que**
ledit actionneur comprend une liaison (86) soutenant en cours de fonctionnement ledit élément (84), ladite liaison étant déplaçable de manière contrôlée, afin de déplacer ledit élément en engagement avec ledit tube (80), et pour déplacer l'élément le long du tube afin de créer ladite succion.

2. Distributeur selon la revendication 1, ledit actionneur étant actionnable pour déplacer de manière répétée ledit élément (84) entre ladite position permettant l'écoulement et ledit engagement avec ledit tube.

3. Distributeur selon la revendication 1, ledit élément comprenant un rouleau (84) d'engagement de tube.

4. Distributeur selon la revendication 1, ladite liaison (86) pouvant être actionnée de manière pneumatique.

5. Distributeur selon la revendication 1, ledit actionneur pouvant fonctionner pour déplacer ledit élément (84) le long d'une voie arquée.

6. Distributeur selon la revendication 1, ledit élément (84) étant mu par un ressort vers ledit tube (80).

7. Distributeur selon la revendication 1, ledit réservoir (50) comprenant un corps (50) de seringue comprenant un piston déplaçable (54) disposé au-dessus du niveau de matière à l'intérieur du corps, ledit piston (54) pouvant se déplacer sous l'influence d'une pression pneumatique appliquée contre la surface du piston, qui est à l'écart de ladite matière.

8. Distributeur selon la revendication 1, ledit actionneur comprenant une liaison mécanique.

9. Distributeur selon la revendication 1, ledit distributeur comprenant un carter (12) soutenant ledit ensemble de régulation de l'écoulement, ledit réservoir (14) et le tube (80) étant reçus à l'intérieur dudit carter.

10. Distributeur selon la revendication 1, comprenant un ressort (98) poussant ledit élément (84) contre ledit tube (80) quand l'élément se trouve dans ladite position de blocage d'écoulement de celui-ci.

11. Distributeur selon la revendication 1, comprenant une pièce (41) de soutien en relation d'opposition vis-à-vis dudit élément (84), alors que ledit tube (80) est disposé entre l'élément et la pièce de soutien, ladite pièce de soutien étant résiliente et déformable quand ledit élément est déplacé vers ladite position de blocage d'écoulement de celui-ci.

12. Procédé de distribution d'une matière fluide (52) depuis un réservoir (14) contenant la matière, où l'on trouve un tube déformable (80) de sortie couplé en cours de fonctionnement avec ledit réservoir (14) et présentant une extrémité (82) de sortie, ledit procédé comprenant les étapes suivantes ;
laisser une quantité voulue de ladite matière s'écouler à partir du réservoir, à travers ledit tube (80) et vers ladite extrémité (82) de sortie ;
puis arrêter l'écoulement de matière par déformation dudit tube (80) de sortie, en créant une force de succion adjacente à ladite extrémité (82) de sortie, afin d'aspirer de la matière proche de l'extrémité de sortie dans le tube (80),
ladite étape de déformation comprenant l'étape de création d'une force appliquée de manière résiliente contre ledit tube (80),
lesdites étapes d'arrêt d'écoulement et de création de succion comprenant l'étape consistant à amener l'élément de déformation de tube à venir en engagement avec ledit tube (80) entre ledit réservoir (50) et ladite extrémité (82) de sortie, et à déplacer l'élément le long du tube (80), dans une direction d'éloignement à partir de ladite extrémité de sortie (82),
**caractérisé en ce qu'**il existe un ensemble (86, 130, 144, 154) de liaison mécanique soutenant ledit élément (84, 132, 150, 158) et comprenant l'étape consistant à provoquer le mouvement de l'ensemble (86, 130, 144, 154) de liaison en provoquant l'engagement dudit élément (84, 132, 150, 158) avec ledit tube (80) et son déplacement le long du tube.

13. Procédé selon la revendication 12, où se trouve un ensemble de liaison supportant ledit élément, et comprenant l'étape de déplacement dudit élément par soumission de l'ensemble de liaison à une pression positive.

14. Procédé selon la revendication 12, comprenant l'étape de création d'une pression positive au sein dudit réservoir, ce qui amène ladite matière à s'écouler à partir du réservoir.

15. Procédé selon la revendication 12, comprenant l'étape consistant à amener un élément de déformation de tube mu par un ressort à venir en engagement avec ledit tube, afin de créer ladite force appliquée avec résilience.

16. Procédé selon la revendication 12, comprenant l'étape consistant à prendre un élément de déformation de tube et une pièce opposée de soutien alors que ledit tube est disposé entre ledit élément et ladite pièce, ladite pièce étant résiliente et déformable, ladite étape de déformation de tube comprenant le déplacement dudit élément en relation de blocage de flux avec ledit tube et la déformation de ladite pièce, ce qui produit ladite force appliquée avec résilience.
